Europäisches Patentamt

European Patent Office

Office européen des brevets

(19)

(11) Veröffentlichungsnummer: **0 282 607**
**B1**

(12) **EUROPÄISCHE PATENTSCHRIFT**

(45) Veröffentlichungstag der Patentschrift:
16.08.90

(51) Int. Cl.⁵: **H03D 1/24**

(21) Anmeldenummer: 87103740.4

(22) Anmeldetag: 14.03.87

(54) Fernsehsignal-Frequenzumsetzungsschaltung.

(43) Veröffentlichungstag der Anmeldung:
21.09.88 Patentblatt 88/38

(45) Bekanntmachung des Hinweises auf die Patenterteilung:
16.08.90 Patentblatt 90/33

(84) Benannte Vertragsstaaten:
DE FR NL

(56) Entgegenhaltungen:
EP-A- 0 062 872
EP-A- 0 122 657
EP-A- 0 180 339
EP-A- 0 201 092
DE-A- 2 905 331
GB-A- 1 565 899
GB-A- 2 170 368

PROCEEDINGS OF THE IRE, Dezember 1956,
Seiten 1703-1705, New York, US; D.K. WEAVER, Jr.: "A
third method of generation and detection of
single-sideband signals"

(73) Patentinhaber: Deutsche ITT Industries GmbH,
Hans-Bunte-Strasse 19 Postfach 840,
D-7800 Freiburg(DE)

(72) Erfinder: Kappeler, Otmar, Dipl.-Ing.,
Zähringerstrasse 22, D-7844 Neuenburg(DE)
Erfinder: Ehrhardt, Dietmar, Dr. Ing., Hägestrasse 34,
D-7800 Freiburg-Hochdorf(DE)

## Beschreibung

Die Erfindung betrifft eine Schaltungsanordnung zur Frequenzumsetzung eines hochfrequent übertragenen Fernsehsignals in das Videoband entsprechend dem Oberbegriff des Anspruchs 1. Derartige Schaltungsanordnungen enthalten üblicherweise einen Hochfrequenzumsetzer, auch Tuner genannt, der das von der Antenne empfangene und ggf. vorverstärkte Signal in einen festen Zwischenfrequenzbereich von z.B. 33,4 MHz bis etwa 40 MHz umsetzt. Die eigentliche Kanalselektion erfolgt hier im Zwischenfrequenzbereich durch das Zwischenfrequenzdurchlaßfilter, das bezuglich seines Durchlaß- und Sperrbereichs nach der jeweiligen Fernsehnorm eng toleriert ist, damit die Nachbarkanäle, insbesondere deren Tonträger, ausgeblendet werden, ohne das eigene bild oder den eigenen Ton zu verzerren. Die Selektionsflanke des Zwischenfrequenzfilters ist an der unteren Bandgrenze bei 33,4 MHz steil. An der oberen Bandgrenze ist für den Bildträger eine Nyquistflanke ausgebildet, die ihre 6-dB-Absenkung bei 38,9 MHz hat und sich dann konstant bis etwa 40 MHz weiter absenkt.

Eine monolithisch intergrierbare Methode der Filterung wird mit dem Tief-Zwischenfrequenzverfahren, nach der "Dritten Methode" , erreicht, weil hierbei die Kanalselektion allein durch einfache Tiefpaßfilterung im Basisband, anstatt der beschriebenen Bandpaßfilterung im Zwischenfrequenzbereich, erreicht wird . Allerdings ist hierzu das hochfrequente Fernsehsignal in zwei exakt gleichen Signalpfaden herunterzumischen, wobei die Phasenlage in den beiden Signalpfaden zueinander genau 90° betragen muß. Das entsprechende Verfahren ist z.B. in "Proceedings of the IRE", 1956, Seiten 1703-1705 in dem Aufsatz von D.K. Weaver, "A Third Method of Generation and Detection of SSB-Signals" grundsätzlich beschrieben.

Eine Schaltungsanordnung für Fernsehsignale, die nach dem Verfahren der Tief-Zwischenfrequenzumsetzung in das Videoband umgesetzt werden, ist in der den Oberbegriff des Anspruchs 1 bildenden EP-A 122 657 beschrieben. Den Vorteilen in der Filterung stehen indessen in der Anwendung auf Fernsehsignale hohe Forderungen an die Genauigkeit der Amplitudengleichheit und an die Genauigkeit der 90°-Phasenbeziehung der beiden Signalpfade gegenüber, weil bei einer geringen Phasenabweichung, z.B. von einigen Graden, bereits ein störendes Moiré im Fernsehbild auftritt, denn der mitübertragene Bildträger kann dann nach der "Dritten Methode" nicht mehr vollständig unterdrückt werden und erscheint durch Mischung mit Bild- oder Tonsignalen als Ton- oder Bildstörung.

Es ist daher Aufgabe der Erfindung, mittels einer geeigneten Schaltungsanordnung die im Oberbegriff des Anspruchs 1 definierte Schaltung so zu optimieren und weiter auszubilden, daß die einfache Kanalselektion der Tief-Zwischenfrequenzumsetzung leichter auf Fernsehsignale anwendbar ist.

Der wesentliche Erfindungsgedanke besteht dabei darin, in einem ersten Schritt das hochfrequent übertragene Fernsehsignal mittels eines Tuners in einen festen Zwischenfrequenzbereich zu übertragen und die eigentliche Kanaltrennung in einem zweiten Schritt nach Art der "Dritten Methode" erst mit dem Ausgangssignal des Tuners durchzuführen. Von Vorteil ist dabei, daß die kritische Hochfrequenzherabmischung nur in einem einzigen Hochfrequenzmischer durchgeführt wird, während die empfindliche Quadraturmischung in einem tieferen und damit unkritischeren Frequenzbereich erfolgt. Zudem findet die Quadraturmischung nur in einem eng begrenzten Frequenzbereich statt, was weiter zur Stabilisierung beiträgt, denn die beiden zur Mischung erforderlichen um 90° gegeneinander phasenverschobenen Mischungssignale sind Festfrequenzsignale und die damit zu mischenden Fernsehsignale liegen innerhalb eines festen Zwischenfrequenzkanals. Damit sind die Anforderungen an die Amplituden- und Phasengleichheit der einzelnen Schaltungsteile leichter realisierbar, auch mittels monolithisch integrierter Schaltungen, denn zusätzliche Abgleichmaßnahmen erübrigen sich.

Die Erfindung wird nun anhand der Figuren der Zeichnung näher erläutert.

Fig. 1 zeigt als Blockschaltbild ein Ausführungsbeispiel der Frequenzumsetzungsschaltung mit Tuner, Tief-Zwischenfrequenzumsetzer und Demodulator,

Fig. 2 zeigt schematisch die Frequenzlage des hochfrequent übertragenen Fernsehsignals mit zwei Nachbarkanälen und dem Spiegelfrequenzsignal,

Fig. 3 zeigt schematisch die Frequenzlage des Fernsehsignals am Ausgang des Tuners,

Fig. 4 zeigt schematisch die Frequenzlage des gefalteten In-Phase- und des gefalteten Quadraturphase-Signals in der Tiefzwischenfrequenzlage, und

Fig. 5 zeigt als Blockschaltbild ein weiteres Ausführungsbeispiel des Tief-Zwischenfrequenzumsetzers.

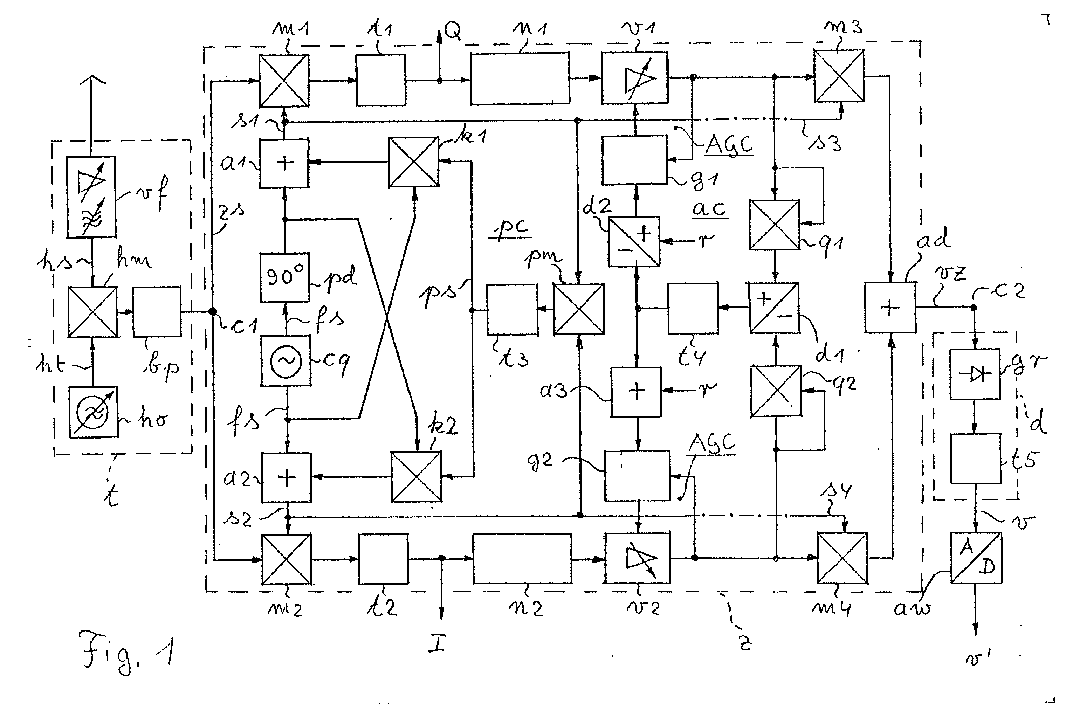

In Fig. 1 ist das Antennensignal dem Tuner t zugeführt, der eingangsseitig einen Vorkreis vf mit Verstärker und Filter enthält. Der Tuner enthält ferner den Hochfrequenzoszillator ho, dessen Ausgangssignal, das Hochfrequenz-Mischungssignal ht, den einen Eingang des Hochfrequenzmischers hm speist, dessen anderem Eingang das hochfrequent übertragene Fernsehsignal hs zugeführt ist. Die Filterung dient der Spiegelfrequenzselektion des Spielgelfrequenzsignals ss, vgl. Fig. 2. Das Ausgangssignal des Hochfrequenzmischers hm ist ferner mittels des Bandpasses bp gesiebt und erscheint als Zwischenfrequenzsignal zs am Eingang c1 des Tief-Zwischenfrequenzumsetzers z.

Nach dem Eingang c1 verzweigt sich die Signalleitung und bildet zwei Signalpfade. Der erste Signalpfad ist in Signalflußrichtung aus der Reihenschaltung von erstem Multiplizierer m1, erstem Tiefpaßfilter t1, erstem Nyquist-Filter n1, erstem regelbaren Verstärker v1 und drittem Multiplizierer m3 gebildet. Genau gleich dazu aufgebaut ist der zweite Signalpfad, der in Signalflußrichtung aus der Reihenschaltung von zweitem Multiplizierer m2, zweitem Tiefpaßfilter t2, zweitem Nyquist-Filter n2, zweitem regelbaren Verstärker v2 und viertem Multiplizierer m4 gebildet ist.

Das Ausgangssignal des ersten Signalpfades, nämlich das Ausgangssignal des dritten Multiplizierers m3, ist dem ersten Eingang und das Ausgangssignal des zweiten Signalpfades, nämlich das Ausgangssignal des vierten Multiplizierers m4, dem zweiten Eingang der Addierstufe ad zugeführt. Deren Ausgangssignal ist das Videosignal vz in einer Zwischenfrequenzlage und zugleich das Ausgangssignal des Tief-Zwischenfrequenzumsetzers an dessen Ausgang c2. Der erste und der zweite Multiplizierer m1, m2 sind Teile des ersten Quadraturmischers im Eingangsteil des Tief-Zwischenfrequenzumsetzers z.

Der erste Quadraturmischer enthält ferner den Oszillator cq, dessen Ausgangssignal, das Festfrequenzsignal fs, über die Reihenschaltung aus 90°-Phasendrehglied pd und erstem Addierer a1 den zweiten Eingang des ersten Multiplizierers m1 speist. Das Festfrequenzsignal fs ist ferner über den zweiten Addierer a2 dem zweiten Eingang des zweiten Multiplizierers m2 zugeführt. Die beiden Addierer a1, a2 sind in den ersten Quadraturmischer als Teile der Phasenkorrekturstufe pc eingefügt, die ferner den Phasendetektor pm, das dritte Tiefpaßfilter t3 und die beiden Korrekturverstärker k1, k2 enthält.

Die Phasenkorrekturstufe pc überwacht die genaue 90°-Phasenlage des ersten und des zweiten Mischungssignals s1, s2 und verändert mittels je eines Korrektursignals, das dem jeweiligen zweiten Eingang des ersten bzw. zweiten Addierers a1, a2 zugeführt wird, die Phasenlage der beiden Mischungssignale. Als Phasendetektor pm dient ein Multiplizierer, dessen beiden Eingängen das erste bzw. das zweite Mischungssignal s1, s2 zugeführt ist und dessen Ausgangssignal tiefpaßgefiltert das Phasenkorrektursignal ps ergibt, dessen Vorzeichen und Betrag ein Maß für die Abweichung der Phasendifferenz vom 90°-Sollwert ist.

Mittels des Phasenkorrektursignals ps werden zwei Korrektursignale erzeugt, deren Phasenlage um 90° gegenüber dem jeweiligen Mischungssignal s1, s2 gedreht ist. Dies wird mittels des ersten bzw. des zweiten, z.B. durch je einen Multiplizierer gebildeten, Korrekturverstärkers k1, k2 erreicht, dessen einer Eingang mit dem Phasenkorrektursignal ps, und dessen anderer Eingang mit dem Festfrequenzsignal fs direkt bzw. mit dem dazu um 90° gedrehten Ausgangssignal des ersten bzw. zweiten Korrekturverstärkers k1, k2 speist den zweiten Eingang des ersten bzw. zweiten Addierers a1, a2.

Durch die vorbeschriebene Überkreuzschaltung liegen somit an den beiden Eingängen des ersten Addierers z1 Signale, die gegeneinander um 90° in der Phase gedreht sind, wobei der Betrag des Korrektursignals im allgemeinen klein gegenüber dem Betrag des Signals am anderen Eingang ist, das im wesentlichen dem ersten Mischungssignal s1 entspricht.

Am zweiten Addierer a2 ist das Korrektursignal dem Betrag nach ebenfalls klein gegenüber dem Festfrequenzsignal fs, das im wesentlichen dem zweiten Mischungssignal s2 entspricht.

Da die Phasenkorrekturstufe pc für die Sollphasenlage auf einer Null-Regelung der beiden Korrektursignale beruht, können die beiden Korrekturverstärker k1, k2 auch nichtlineare Kennlinien aufweisen; der Amplituden- und Phasengang muß jedoch zueinander gleich sein. Es ist noch darauf hinzuweisen, daß die Signale der Phasenkorrekturstuf pc bis auf das tiefpaßgefilterte Phasenkorrektursignal ps alles Signale einer einzigen Frequenz, aber unterschiedlicher Phasenlage sind. Die Frequenz ist dabei diejenige des Festfrequenzsignals fs.

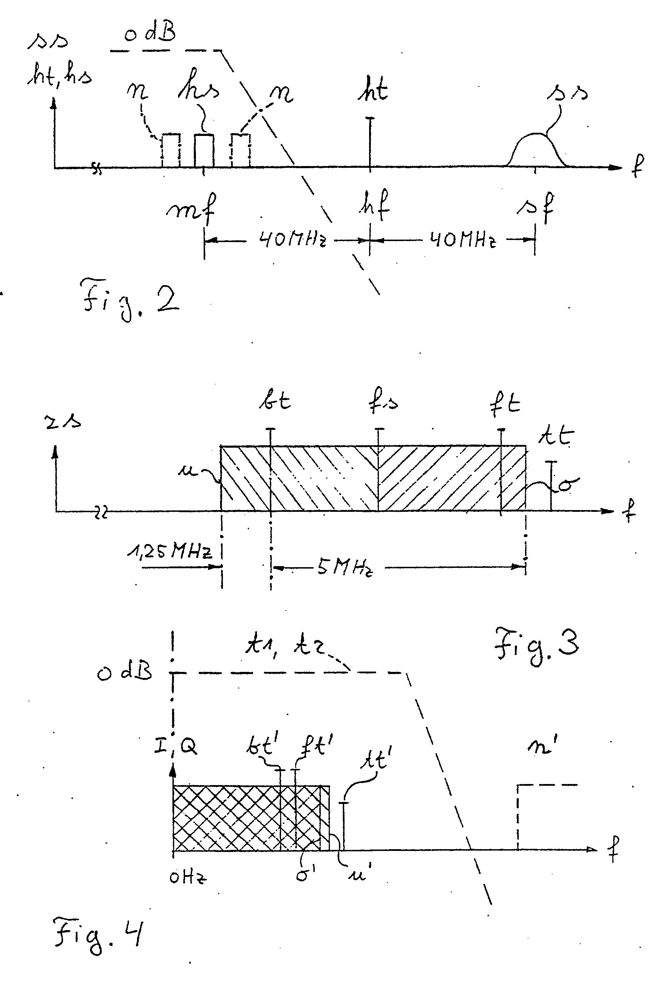

In Fig. 3 ist schematisch die Frequenzlage des Zwischenfrequenzsignals zs mit dem darin enthaltenen Bildträger bt, dem Farbträger ft und dem Tonträger tt dargestellt. In dem ersten Quadraturmischer des Tief-Zwischenfrequenzumsetzers z findet eine Umsetzung des Zwischenfrequenzsignals zs in die Tiefzwischenfrequenzlage, nämlich in das Basisband, derart statt, daß es gleichsam um 0 Hz "gefaltet" scheint. Dies wird dadurch erreicht, daß die Frequenz des Oszillators cq, zwischen dem Bildträger bt und dem Farbträger ft liegt, vgl. das Festfrequenzsignal fs in Fig. 3.

Das Ausgangssignal des ersten Multiplizierers m1 ist im ersten Tiefpaßfilter t1 grob gefiltert und ergibt das gefaltete Quadraturphase-Signal Q. Entsprechend ist das Ausgangssignal des zweiten Multiplizierers m2 ebenfalls grob tiefpaßgefiltert und ergibt das gefaltete In-Phase-Signal I.

Da das Festfrequenzsignal fs als Mischungssignal bei der ersten Quadraturmischung mitten im Zwischenfrequenzsignal zs liegt, wird das Festfrequenzsignal bekanntlich in den Frequenzursprung, also 0 Hz, transformiert. Der ursprünglich unterhalb des Festfrequenzsignals fs liegende Anteil des Zwischenfrequenzsignals zs scheint somit gleichsam um den Frequenzursprung gefaltet und ersreckt sich in den positiven Frequenzbereich. Die Mehrdeutigkeit des In-Phase- und des Quadraturphase-Signals I, Q läßt sich nach Weaver a.a.O. wieder rückgängig machen.

Das erste und das zweite Nyquist-Filter n1, n2 sind wegen des restseitenbandübertragenen Fersehsignals erforderlich. Der 6-dB-Punkt des Nyquist-Filters wird so festgelegt, daß in den beiden gefalteten Signalen I, Q der gefaltete Bildträger bt' auf diese Frequenz zu liegen kommt. Bei dem ersten und zweiten Nyquist-Filter n1, n2 handelt es sich eigentlich um Tiefpaß-Filter, deren Flanke im Bereich der oberen Grenzfrequenz eben als Nyquist-Flanke ausgebildet ist.

Den Beiden Nyquist-Filtern n1, n2 folgt jeweils eine Amplitudenregelstufe AGC, die als Regelschleife den ersten bzw. zweiten regelbaren Verstärker v1, v2 und den ersten bzw. zweiten Komparator g1, g2 enthält, der das Ausgangssignal des jeweiligen regelbaren Verstärkers v1, v2 mit dem Referenzsignal r vergleicht und entsprechend die Verstärkung verändert (vgl. Fig. 1).

Das Referenzsignal r ist den beiden Komparatoren g1, g2 nicht direkt zugeführt, sondern beim ersten Komparator g1 über den zweiten Subtrahierer d2 und beim zweiten Komparator g2 über den dritten Addierer a3. Diese beiden Stufen sind bereits Teile der Amplitudenkorrekturstufe ac, die ferner die beiden Quadrierer q1, q2, den ersten Subtrahierer d1, und das vierte Tiefpaßfilter t4 enthält. Die Amplitudenkorrekturstufe ac verändert den Betrag des Referenzsignals r additiv oder subtraktiv um den Korrekturbetrag, und zwar gegensinnig bezüglich der beiden Signalpfade.

Die Regelung der Amplitudengleichheit erfolgt nach der Methode, nach der für amplitudengleiche sinusförmige Signale die mittlere Differenz ihrer Quadrate zu null wird. So speist der Ausgang des am ersten Signalpfad angeschlossenen ersten Quadriers q1 den Minuend-Eingang und der Ausgang des am zweiten Signalpfad angeschlossenen zweiten Quadrierers q2 den Subtrahend-Eingang des ersten Subtrahierers d1. Dessen Ausgangssignal wird im vierten Tiefpaßfilter t4 geglättet und stellt das Korrektursignal dar, das den Subtrahend-Eingang des zweiten Subtrahierers d2 und den zweiten Eingang des dritten Addierers a3 speist. So wird für den ersten bzw. zweiten Signalpfad das Referenzsignal r um den Korrekturbetrag verkleinert bzw. vergrößert.

Die nach der "Dritten Methode" erforderliche zweite Frequenzumsetzung findet im dritten um im vierten Multiplizierer m3, m4 statt. Das der Frequenzumsetzung im erten Signalpfad dienende dritte Mischungssignal s3 und das der Frequenzumsetzung im zweiten Signalpfad dienende vierte Mischungssignal s4 sind zueinander frequenzgleich, aber um 90° in der Phase verschoben. Bei geeigneter Wahl dieser Frequenz führt bekanntlich die Frequenzumsetzung genau ins Videoband, so daß eine weitere Demodulation entfallen kann. Dies ist z.B. der Fall, wenn durch die Frequenzumsetzung der gefaltete Bildträer bt' in den Frequenzursprung transformiert wird.

Bei dem in Fig. 1 gezeigten Ausführungsbeispiel ist durch eine strichpunktierte Linie gezeigt, daß das dritte bzw. vierte Mischungssignal s3, s4 auch identisch mit dem ersten bzw. zweiten Mischungssignal s1, s2 sein kann, die wie beschrieben sehr genau bezüglich der 90°-Phaseneinstellung sind. In diesem Fall liegt das Ausgangssignal der beiden Multiplizierer m3, m4, nicht mehr im Videoband, sondern ca. 40 MHz darüber. Daher ist dem Tief-Zwischenfrequenzumsetzer z der Demodulator d nachgeschaltet, der im einfachsten Fall den Gleichrichter gr mit dem in Signalflußrichtung nachfolgenden fünften Tiefpaßfilter t5 enthält. Der Ausgang liefert das analoge Videosignal v in der Videobandlage, das für eine z.B, weitere digitale Signalverarbeitung im Analog-Digital-Wandler aw in das digitalisierte Videosignal v' umgewandelt ist. Das analoge und natürlich auch das digitale Videosignal v, v' darf keine Tonanteile mehr enthalten. Diese sind entweder bereits im ersten und zweiten Nyquist-Filter n1, n2 genügend weit abgesenkt worden, oder dies erfolgt mittels des fünften Tiefpaßfilters t5 oder einer unter dem Namen "Tonfalle" bekannten Filterschaltung, über die das analoge Videosignal v geführt ist.

Das Quadraturphase-Signal Q und das In-Phase-Signal I ist herausgeführt, um es einer in Fig. 1 nicht mehr gezeigten Tondemodulatorschaltung zuzuführen. Die dort zu verwendenden Signale sind vor den beiden Nyquist-Filtern n1, n2 abgegriffen, weil durch die Nyquist-Flanke der gefaltete Tonträger tt' eventuell schon zu stark abgesenkt ist. Der Durchlaßbereich des erten und des zweiten Tiefpassfilters t1, t2 ist mindestens so groß wie die halbe Signalbandbreite des Videosignals v, z.B. 3,5 MHz, so daß das In-Phase-Signal I und das Quadraturphase-Signal Q nicht begrenzt werden. Bei dem ersten und dem zweiten Tiefpaßfilter t1, t2 handelt es sich nur um eine relativ grobe Vorselektion.

Wird zwischen dem Ausgang des ersten bzw. des zweiten Tiefpaßfilters t1, t2 und dem Signalabgriff für das Quadraturphase- bzw. das In-Phase-Signal Q, I ein erster bzw. ein dazu identischer zweiter Analog-Digitalwandler eingefügt, dann sind die sich daran in Signalflußrichtung anschließenden Stufen als digitale Stufen auszuführen. Damit ist die Signalverarbeitung in den beiden Signalpfaden unabhängig von äußeren Störeinflüssen, wie Temperatur, Störeinkopplungen und sonstigen Störgrößen , wie z.B. Nichtlinearitäten. Die Gleichheit der beiden Signalpfade ist somit ab der Digitalisierung gewährleistet. Eingeschlossen ist dabei die Realisierbarkeit von aufwendigen digitalen Filterstrukturen, die als Analogfilter monolithisch nicht intergrierbar sind.

Das erste und das zweite Tiefpaßfilter t1, t2 sind bezüglich der nachfolgenden Digitalisierung reine Anti-Alias-Filter, die im Analogsignal bekanntlich Frequenzanteile unterdrücken, die höher als die halbe Abtastfrequenz der Digitalisierung sind. Im eigentlichen Signalband wirken sich die Anti-Alias-Filter jedoch nicht aus, sie sind dort voll durchlässig. Diese beiden Forderungen sind meist leicht mit rein monolithisch integrierbaren Schaltungsteilen zu realisieren, wenn die Abtastfrequenz deutlich über der doppelten maximalen Signalfrequenz liegt, was in der Regel der Fall ist.

Als drittes bzw. viertes Mischungssignal dient das digitale Ausgangssignal des digitalen ersten bzw. zweiten regelbaren Verstärkers. Es liegt somit eine Quadraturbildung und Gleichrichtung in den beiden Signalpfaden vor. Die Ausgangssignale dieser beiden Quadrierer werden in der digitalen Addierstufe addiert, danach wird in einer digitalen Wurzelbildungsstufe die Quadraturwurzel aus dem Summenwert gebildet und diese Quadraturwurzel stellt das digitalisierte Fernsehsignal in der Videobandlage dar, das somit das digitalisierte Videosignal v' ist. Der im Ausführungsbeispiel nach Fig. 1 gezeigte Demodulator d und der Analog-Digital-Wandler aw entfallen dann. Auch hier sind noch störenden Tonanteile im Videosignal vor oder nach der Digitalisierung herauszufiltern. Es sind ferner aus dem Bereich der digitalen Signalverarbeitung auch andere Verfahren bekannt, die hier zur Betragsbildung eingesetzt werden können und eventuell die Quadrierung oder Wurzelbildung vermeiden.

Aus der schematischen Frequenz-Darstellung nach den Fig. 2 und 3 ist ersichtlich, daß das Hochfrequenz-Mischungssignal ht des Hochfrequenzoszillators ho im Tuner t 40 MHz neben das hochfrequent übertragene Fernsehsignal hs, dessen Kanalbreite etwa 7 MHz beträgt, gesetzt wird. Der Kanalabstand benachbarter Fernsehkanäle beträgt dabei z.B. 8 MHz. Die gestrichelte Linie in Fig. 2 gibt etwa die erforderliche Spiegelfrequenzunterdrückung im Tuner t an. Da die Frequenz hf des Hochfrequenz-Mischungssignals ht definitionsgemäß genau zwischen der Signalmittenfrequenz mf des hochfrequent übertragenen Fernsehsignals hs und der Mittenfrequenz der Spiegelfrequenzsignals ss mit der Spiegelfrequenz sf oder eines entsprechenden Fremdsignals liegt, überdecken sich die beiden Signale hs, ss nach der Frequenzumsetzung voll und lassen sich nicht mehr voneinander trennen. Daher muß bereits vor der Hochfrequenzmischung das störende Spiegelfrequenzsignal ss durch das Spiegelfrequenzfilter im Vorkreis vf genügend weit abgesenkt werden. Das Zwischenfrequenzsignal zs in Fig. 3 und das Festfrequenzsignal fs liegt somit im Bereich von 40 MHz. Die Frequenz des Festfrequenzsignals fs wäre in diesem Fall beim PAL-Fernsehstandard z.B. 36,3 MHz. In Fig. 2 sind ferner strichpunktiert zwei Nachbarkanäle n eingezeichnet.

In Fig. 4 sind das In-Phase- und das Quadratur-Phase-Signal I, Q, die beide gefaltet sind, in ihrem Frequenzverlauf schematisch dargestellt. Wie in Fig. 3 sind die beiden durch das Festfrequenzsignal fs festgelegten Abschnitte mit unterschiedlicher Schraffur gekennzeichnet und zeigen, wie diese sich nach der Faltung teilweise überdecken. Und zwar wird die untere Bandgrenze u des Restseitenbandes zur transformierten Bandgrenze u' und entsprechend die obere Videobandgrenze o zur transformierten oberen Bandgrenze o'. Im dargestellten Fall befindet sich der gefaltete Tonträger tt' in einem solchen Abstand vom gefalteten Bildträger bt', daß ihn die auf den gefalteten Bildträger bt' bezogene Nyquist-Flanke bereits genügend weit absenkt, so daß er bei der Bildwiedergabe nicht mehr stört. Ferner ist der jeweilige Durchlaßbereich des ersten und zweiten Tiefpaßfilters t1, t2, gestrichelt und schematisch dargestellt, wobei der Nachbarkanal n' möglichst zu unterdrücken ist, während das eigene Signal voll im Durchlaßbereich liegen soll.

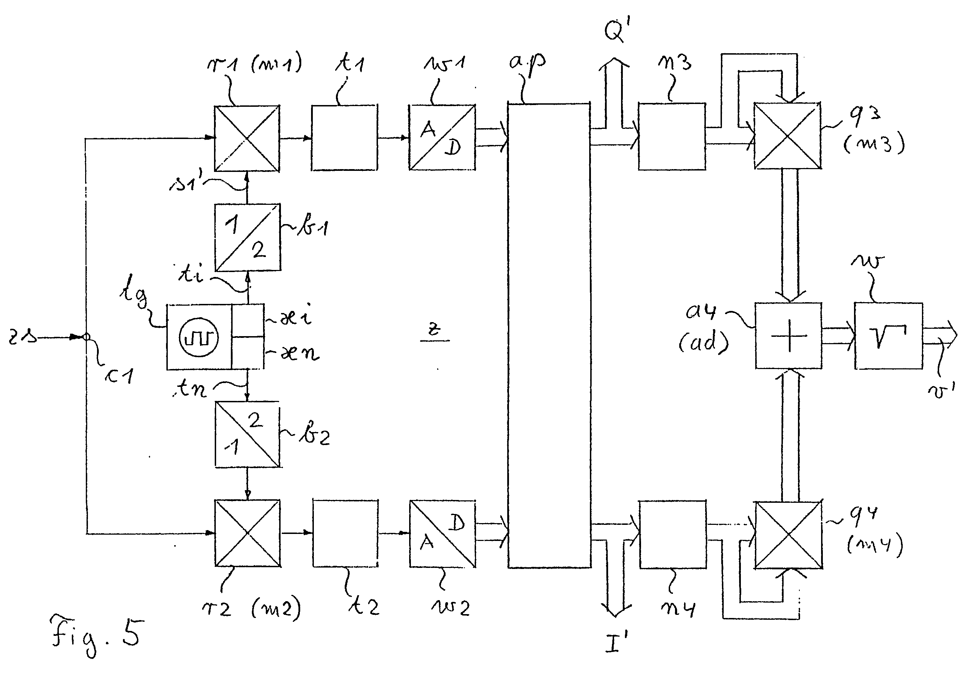

In Fig. 5 ist ein besonders vorteilhaftes Ausführungsbeispiel des Tief-Zwischenfrequenzumsetzers z als Blockschaltbild gezeigt. Der wesentliche Unterschied gegenüber den vorbeschriebenen Beispielen besteht darin, daß die erste Quadraturmischung statt des ersten und zweiten Multiplizierers m1, m2 den ersten und zweiten Ringmodulator r1, r2 verwendet. Das erste und zweite Mischungssignal s1, s2 dienen somit nur der reinen Schaltfunktion in den beiden Ringmischern r1, r2 und sind daher von ihrer Amplitude unabhängig. Dies erleichtert die Integrierbarkeit des ersten Quadraturmischers, denn die Gleichheit der beiden Ringmodulatoren r1, r2 ist durch den reinen Schalterbetrieb leichter zu realisieren. Als Schaltsignale eignen sich anstatt des sinusförmigen ersten und zweiten Mischungssignals s1, s2 besser rechteckförmige oder steilflankige Taktsignale. Somit ist der erste bzw. zweite Ringmodulator r1, r2 an seinem Schaltereingang mit dem ersten bzw. zweiten Taktsignal s1', s2' gespeist, wobei deren Impuls-Pausen-Verhältnis möglichst genau 1:1 beträgt und deren Frequenz derjenigen des Festfrequenzsignals fs entspricht.

Die Verwendung von Ringmodulatoren im ersten Quadraturmischer ist möglich, weil das Zwischenfrequenzsignal zs ein bandbegrenztes Signal ist. Die bei der Ringmodulation auftretende dritte, fünfte usw. Harmonische des Festfrequenzsignals fs liefert keine unerwünschten Mischprodukte in der Basisbandlage, da bei diesen Harmonischen dann kein Eingangssignal vorliegt. Höherfrequente Mischprodukte (wie z.B. fs + hs) werden durch das jeweils nachfolgende Tiefpaßfilter t1, t2, das auch als Anti-Alias-Filter für die Digitalisierung wirksam ist, herausgefiltert. Für die Dimensionierung des Bandpaßes bp im Tuner t ist somit vor allem die Frequenz der Festfrequenzsignals fs, sowie der Durchlaßbereich des Anti-Alias-Filters, dessen Bandbreite wiederum vom Digitalisierungstakt abhängig ist, zu berücksichtigen.

Der Erzeugung des um 90° in der Phase gegeneinander verschobenen ersten und zweiten Taktsignals s1', s2' dient der Taktgenerator tg, der an seinem invertierenden bzw. nichtinvertierenden Ausgang xi, xn das invertierte bzw. dazu nichtinvertierte Taktsignal ti, tn liefert, dessen Frequenz das doppelte derjenigen des ersten oder zweiten Taktsignals s1', s2' und damit auch derjenigen des Festfrequenzsignals fs ist, wobei das zugehörige Impuls-Pausen-Verhältnis 1:1 beträgt. Das invertierte bzw. das nichtinvertierte Taktsignal ti, tn speist den einstufigen binären ersten bzw. zweiten Frequenzteiler b1, b2, wodurch die Taktfrequenz halbiert wird, um die 90°-Phasenbeziehung des ersten und zweiten Taktsignals s1', s2' herzustellen.

Anders als in Fig. 1 ist die Phasenkorrekturstufe pc und die Amplitudenkorrekturstufe ac in einer einzigen digitalen Schaltung zusammengefaßt, nämlich in der Phasen- und Amplitudenkorrekturstufe pa. Diese ist in die beiden Signalpfade zwischen den ersten Analog-Digital-Wandler w1 und die Auskopplung für das digitale Quadraturphase-Signal Q' und zwischen den zweiten Analog-Digital-Wandler w2 und die Auskopplung für das digitale In-Phase-Signal I' eingefügt. Ein Ausführungsbeispiel dieser Korrekturschaltung ist rein beispielsweise in der europäischen Patentanmeldung mit dem Aktenzeichen 86 10 3522.8 beschrieben. Es handelt sich darin um die Angabe einer Regelschaltung zur Regelung der Phasendifferenz und der jeweiligen Amplitude von zwei ca. 90°-Phasenverschiebung aufweisenden digitalen Signalen.

Die beiden in der Phase und in der Amplitude geregelten Digitalsignale der beiden Signalpfade sind jeweils dem digitalen ersten oder digitalen zweiten Nyquist-Filter n3, n4 zugeführt, die für die nachfolgende Bildsignalverarbeitung auch die Tonsignalunterdrückung mitenthalten können. Das Ausgangssignal des digitalen ersten bzw. zweiten Nyquist-Filters n3, n4 ist mittels des dritten bzw. vierten Quadrierers q3, q4 quadriert und die beiden quadrierten Werte sind mittels der digitalen Addierstufe a4 summiert.

Das Ausgangssignal der digitalen Addierstufe a4 ist der quadrierte und damit gleichgerichtete Signalwert des digitalisierten Fernsehsignals in der Videobandlage, das nach der digitalen Wurzelbildung in der sich in Signalflußrichtung anschließenden Quadratwurzel-Rechenstufe w das eigentliche digitalisierte Videosignal v' in der Videobandlage ergibt. Ein eigener Demodulator d wie in Fig. 1 ist somit nicht mehr erforderlich. Die rechnerische Demodulation über die beschriebene Betragsbildung bei Quadratursignalen ist analog kaum möglich; als digitale Lösung ist es nur eine Frage des entsprechenden Schaltungsaufwandes, der aber monolithisch leicht integrierbar ist.

**Patentansprüche**

1. Schaltungsanordnung zur Frequenzumsetzung eines hochfrequent übertragenen Fernsehsignals (hs) ins Videoband
- mit einem ersten und zweiten Signalpfad, die eingangsseitig miteinander verbunden sind und die jeweils in Signalflußrichtung in dieser Reihenfolge den ersten Eingang eines ersten bzw. zweiten Multiplizierers (m1, m2), ein erstes bzw. zweites Tiefpaßfilter (t1, t2) und den ersten Eingang eines dritten bzw. vierten Multiplizierers (m3, m4) enthalten,
- mit einer Addierstufe (ad), deren einer Eingang mit dem Ausgang des dritten und deren anderer Eingang mit dem Ausgang des vierten Multiplizierers (m3, m4) verbunden ist,
- mit einer Phasen- (pc) und mit einer Amplitudenkorrekturstufe (ac), die der Einstellung der 90 °-Signalphasenlage zwischen den Signalpfaden und deren Amplitudengleichheit untereinander dienen, wobei
-- dem zweiten Eingang des ersten bzw. zweiten Multiplizierers (m1, m2) ein erstes bzw. ein dazu um 90°-phasenverschobenes zweites Mischungssignal (s1, s2) zugeführt ist, welches das dem jeweiligen ersten Eingang zugeführte Signal in die Tief-Zwischenfrequenzlage umsetzt,
-- dem zweiten Eingang des dritten bzw. vierten Multiplizierers (m3, m4) ein drittes bzw. ein dazu um 90°-phasenverschobenes viertes Mischungssignal (s3, s4) zugeführt ist,
-- die Frequenz des ersten und des zweiten Mischungssignals (s1, s2) innerhalb der Bandgrenze des den beiden Signalpfaden eingangsseitig zugeführten Signals liegt und
-- der Durchlaßbereich des erten und des zweiten Tiefpaßfilters (t1, t2) mindestens so groß wie die halbe Signalbandbreite des Videosignals (v) ist,
<u>gekennzeichnet durch folgende Merkmale:</u>
- den beiden Signalpfaden ist ein Tuner (t) vorgeschaltet, der das hochfrequent übertragene Fernsehsignal (hs) in ein Zwischenfrequenzsignal (zs) umsetzt,
- die Frequenz des ersten und des zweiten Mischungssignals (s1, s2) ist konstant und unabhängig von der Frequenzlage des hochfrequent übertragenen Fernsehsignals (hs),
- jeweils eine Reihenschaltung in Signalflußrichtung aus einem ersten bzw. zweiten Nyquist-Filter (n1, n2) und einem ersten bzw. zweiten regelbaren Verstärker (v1, v2) ist zwischen dem ersten bzw. zweiten Tiefpaßfilter (t1, t2) und dem dritten bzw. vierten Multiplizierer (m3, m4) angeordnet,
- die 6-dB-Frequenz des ersten und zweiten Nyquist-Filters (n1, n2) ist gleich der Frequenz des gefalteten Bildträgers (bt') im Ausgangssignal der ersten und zweiten Multiplizierers (m1, m2),
- der Ausgang des ersten bzw. zweiten regelbaren Verstärkers (v1, v2) ist mit dem Signaleingang eines ersten bzw. zweiten Komparators (g1, g2) verbunden, dessen jeweiliger Ausgang am Steuereingang des ersten bzw. zum ersten identischen zweiten regelbaren Verstärkers (v1, v2) liegt,
- ein Demodulator (d) ist dem Ausgang der Addierstufe (ad) nachgeschaltet und liefert das demodulierte Fernsehsignal (= Videosignal (v)), und
- für das Ausgangssignal des ersten Tiefpaßfilters (t1) (= Quadraturphase-Signal (Q)) und das Ausgangssignal des zweiten Tiefpaßfilters (t2) (= In-Phase-Signal (I)) ist jeweils ein Signalabgriff zum Anschluß einer Tondemodulatorschaltung vorgesehen.

2. Schaltungsanordnung nach Anspruch 1, gekennzeichnet durch folgende Merkmale:
- in der Phasenkorrekturstufe (pc) ist das erste und das zweite Mischungssignal (s1, s2) jeweils einem Eingang eines Phasendetektors (pm) zugeführt,
- am Ausgang des Phasendetektors (pm) liegt ein drittes Tiefpaßfilter (t3), dessen Ausgang mit dem Steuereingang eines ersten und eines dazu identischen zweiten Korrekturverstärkers (k1, k2) verbunden ist,
- dessen Signaleingang liegt direkt bzw. über ein 90°-Phasendrehglied (pd) am Ausgang eines Oszillators (cq) konstanter Frequenz,
- der Ausgang des 90°-Phasendrehglieds (pd) ist mit dem ersten Eingang eines ersten Addierers (a1) verbunden, dessen zweiter Eingang am Ausgang des ersten Korrekturverstärkers (k1) liegt,
- der Ausgang des Oszillators (cq) ist mit dem ersten Eingang eines zweiten Addierers (a2) verbunden, dessen zweiter Eingang am Ausgang des zweiten Korrekturverstärkers (k2) liegt, und
- die Ausgangssignale des ersten bzw. zweiten Addierers (a1, a2) sind das erste bzw. zweite Mischungssignal (s1, s2).

3. Schaltungsanordnung nach Anspruch 1 oder 2, gekennzeichnet durch folgende Merkmale:
- in der Amplitudenkorrekturstufe (ac) ist das Ausgangssignal des ersten bzw. zweiten regelbaren Verstärkers (v1, v2) einem ersten bzw. zweiten Quadrierer (q1, q2) zugeführt, dessen jeweiliger Ausgang am Minuend- bzw. am Subtrahend-Eingang eines ersten Substrahierers (d1) liegt,
- dem Ausgang des ersten Subtrahierers (d1) ist ein viertes Tiefpaßfilter (t4) nachgeschaltet, dessen Ausgang mit dem Subtrahend-Eingang eines zweiten Subtrahierers (d2) und mit dem ersten Eingang eines dritten Addierers (a3) verbunden ist,
- der Ausgang des zweiten Subtrahierers (d2), dessen Minuend-Eingang ein Referenzsignal (r) zugeführt ist, liegt am Referenzeingang des ersten Komparators (g1), und
- der Ausgang des dritten Addierers (a3), desen zweitem Eingang der Referenzwert (r) zugeführt ist, liegt am Referenzeingang des zweiten Komparators (g2).

4. Schaltungsanordnung nach einem der Ansprüche 1 bis 3, dadurch gekennzeichnet, daß als drittes bzw. viertes Mischungssignal (s3, s4) das erste bzw. zweite Mischungssignal (s1, s2) dient.

5. Schaltungsanordnung nach einem der Ansprüche 1 bis 4, dadurch gekennzeichnet, daß das Ausgangssignal des Demodulators (d) mittels eines Analog-Digital-Wandlers (aw) digitalisiert ist.

6. Schaltungsanordnung nach einem der Ansprüche 1 bis 3, gekennzeichnet durch folgende Merkmale:
- zwischen dem Ausgang des ersten bzw. zweiten Tiefpaßfilters (t1, t2) und dem Signalabgriff für das Quadraturphase- bzw. das In-Phase-Signal (Q, I) ist ein erster bzw. ein dazu identischer zweiter Analog-Digital-Wandler (w1, w2) eingefügt,
- die sich daran in Signalflußrichtung anschließenden Stufen sind als digital arbeitende Stufen ausgeführt,
- als digitales drittes bzw. viertes Mischungssignal (s3, s4) dient das jeweilige Eingangssignal des digitalen dritten bzw. vierten Multiplizierers (m3, m4), der somit einen dritten bzw. einen vierten Quadrierer (q3, q4) bildet,
- das Ausgangssignal der Addierstufe (ad), nämlich einer digitalen Addierstufe (a4), deren jeweiliger Eingang vom dritten bzw. vierten Quadrierer (q3, q4) gespeist ist, ist der quadrierte Signalwert des digitalisierten Fernsehsignals in der Videobandlage, das nach der digitalen Wurzelbildung in einer Quadratwurzel-Rechenstufe (w) das eigentliche digitalisierte Videosignal (v') in der Videobandlage ergibt, und
- der Demodulator (d) entfällt.

7. Schaltungsanordnung nach Anspruch 6, gekennzeichnet durch folgende Merkmale:
- das erste bzw. zweite Mischungssignal (s1, s2) ist ein rechteckförmiges erstes bzw. zweites Taktsignal (s1', s2') mit einem Impuls-Pausen-Verhältnis von 1:1,
- der erste bzw. zweite Multiplizierer (m1, m2) ist durch einen ersten bzw. zweiten Ringmodulator (r1, r2) ersetzt, dessen jeweiligem Signaleingang das Zwischenfrequenzsignal (zs) und dessen jeweiligem Schaltereingang das erste bzw. zweite Taktsignal (s1', s2') zugeführt ist,
- das Zwischenfrequenzsignal (zs) ist ein mittels eines im Tuner (t) enthaltenen Bandpaßes (bp) gefiltertes Signal und
- die Phasen- und die Amplitudenkorrekturstufe (pc, ac) sind als eine einzige und rein digital arbeitende Phasen- und Amplitudenkorrekturstufe (pa) ausgeführt, die als eine Teilschaltung in die beiden Signalpfade nach dem ersten bzw. zweiten Analog-Digital-Wandler (w1, w2) und dem Abgriff für das digitale Quadraturphase- bzw. In-Phase-Signal (Q', I') eingefügt ist.

8. Schaltungsanordnung nach Anspruch 7, gekennzeichnet durch folgende Merkmale:
- ein Taktgenerator (tg) erzeugt an seinem invertierenden bzw. nichtinvertierenden Ausgang (xi, xa) ein invertiertes bzw. nichtinvertiertes Taktsignal (ti, tn), dessen Frequenz das doppelte derjenigen des ersten oder zweiten Taktsignals (s1', s2') und dessen Impuls-Pausen-Verhältnis 1:1 ist, und
- ein binärer einstufiger erster bzw. zweiter Frequenzteiler (b1, b2) erzeugt aus dem invertierten bzw. nichtinvertierten Taktsignal (ti, tn) das erste bzw. zweite Taktsignal (s1', s2').

## Claims

1. Circuit arrangement for converting the frequency of a radio-frequency television signal (hs) to the video band, comprising
- a first signal path and a second signal path interconnected at the input end containing, in this order in the direction of signal flow, the first inputs of a first multiplier (m1) and a second multiplier (m2), respectively, a first low-pass filter (t1), and a second low-pass filter (t2), respectively, and the first inputs of a third multiplier (m3) and a fourth multiplier (m4), respectively,
- an adding stage (ad) having one input connected to the output of the third multiplier (m3) and the other to the output of the fourth multiplier (m4),
- a phase-correcting stage (pc) and an amplitude-correcting stage (ac) which serve to establish the 90° phase relationship and amplitude equality between the signal paths, with
- the second inputs of the first multiplier (m1) and the second multiplier (m2) being fed, respectively, with a first translating signal (s1) and a second translating signal (s2) in quadrature with the first translating signal (s1), which convert the signals applied to the respective first inputs to the low IF value,
- the second inputs of the third multiplier (m3) and the fourth multiplier (m4) being fed, respectively, with a third translating signal (s3) and a fourth translating signal (s4) in quadrature with the third translating signal (s3),
- the frequencies of the first and second translating signals (s1, s2) lying within the band limits of the signals applied to the two signal paths at the input end, and
- the passbands of the first and second low-pass filters (t1, t2) being at least equal to half the bandwidth of the video signal (v), characterized by the following features:
- The two signal paths are preceded by a tuner (t) which converts the radio-frequency television signal (hs) into an intermediate-frequency signal (zs);
- the frequencies of the first and second translating signals (s1, s2) are stable and independent of the frequency of the radio-frequency television signal (hs);
- a series combination of a first Nyquist filter (n1) and a first variable-gain amplifier (v1) and a series combination of a second Nyquist filter (n2) and a second variable-gain amplifier (v2) are inserted between the first low-pass filter (t1) and the third multiplier (m3) and between the second low-pass filter (t2) and the fourth multiplier (m4), respectively;
- the 6-dB frequencies of the first and second Nyquist filters (n1, n2) are equal to the frequency of the folded picture carrier (bt') in the output signals of the first and second multipliers (m1, m2);
- the outputs of the first variable-gain amplifier (v1) and the second variable-gain amplifier (v2), which is identical with the first variable-gain amplifier (v1), are coupled, respectively, to the signal inputs of a first comparator (g1) and a second comparator (g2) having their outputs connected to the control inputs of the first variable-gain amplifier (v1) and the second variable-gain amplifier (v2), respectively;
- the output of the adding stage (ad) is followed by a detector (d) which provides the demodulated television signal [= video signal (v)], and
- two taps for connection of a sound demodulator circuit are provided for the output signal of the first lowpass filter (t1) [= quadrature-phase signal (q)] and the output signal of the second lowpass filter (t2) [= inphase signal (l)], respectively.

2. A circuit arrangement as claimed in claim 1, characterized by the following features:
- In the phase-correcting stage (pc), the first and second translating signals (s1, s2) are each applied to one input of a phase detector (pm);
- the output of the phase detector (pm) is followed by a third low-pass filter (t3) having its output connected to the control inputs of a first correction amplifier (k1) and a second correction amplifier (k2) which is identical with the first correction amplifier (k1);
- the signal input of the first correction ampliifer (k1) is connected to the output of a fixed-frequency oscillator (cq) directly, and that of the second correction amplifier (k2) via a 90° phase shifter (pd);
- the output of the 90° phase shifter (pd) is coupled to the first input of a first adder (a1) having its second input connected to the output of the first correction amplifier (k1);
- the output of the fixed-frequency oscillator (cq) is coupled to the first input of a second adder (a2) having its second input connected to the output of the second correciton amplifier (k2), and
- the outputs of the first and second adders (a1, a2) are the first translating signal (s1) and the second translating signal (s2), respectively.

3. A circuit arrangement as claimed in claim 1 or 2, characterized by the following features:
- In the amplitude-correcting stage (ac), the outputs of the first and second variable-gain amplifiers (v1, v2) are applied, respectively, to a first squarer (q1) and a second squarer (q2) having their outputs connected, respectively, to the minuend input and the substrahend input of a first subtracter (d1);
- the output of the first subtracter (d1) is followed by a fourth low-pass filter (t4) having its output connected to the subtrahend input of a second subtracter (d2) and to the first input of a third adder (a3);
- the output of the second subtracter (d2), whose minuend input is fed with a reference signal (r), is coupled to the reference input of the first comparator (g1), and
- the output of the third adder (a3), whose second input is fed with the reference signal (r), is coupled to the reference input of the second comparator (g2).

4. A circuit arrangement as claimed in any one of claims 1 to 3, characterized in that the first and second translating signals (s1, s2) serve as the third translating signal (s3) and the fourth translating signal (s4), respectively.

5. A circuit arrangement as claimed in any one of claims 1 to 4, characterized in that the output of the detector (d) is digitized by means of an analog-to-digital converter (aw).

6. A circuit arrangement as claimed in any one of claims 1 to 3, characterized by the following features:
- A first analog-to-digital converter (w1) is inserted between the output of the first low-pass filter (t1) and the tap for the quadrature-phase signal (Q), and a second analog-to-digital converter (w2), which is identical with the first analog-to-digital converter (w1), is inserted between the output of the second low-pass filter (t2) and the tap for the in-phase signal (l);
- the stages following the first and second analog-to-digital converters (w1, w2) are designed as digital stages;
- the third and fourth digital translating signals (s3, s4) are, respectively, the input signal of the third digital multiplier (m3), which thus forms a third squarer (q3), and the input signal of the fourth digital multiplier (m4), which thus forms a fourth squarer (q4)
- the output signal of the adding stage (ad), which is a digital adding stage (a4) whose two inputs are fed by the third squarer (q3) and the fourth squarer (q4), respectively, is the squared value of the digitized television signal at the video band, which is passed through a digital square-root extractor (w) to obtain the digitized video signal (v') at the video band, and
- the detector (d) is omitted.

7. A circuit arrangement as claimed in claim 6, characterized by the following features:
- The first translating signal (s1) and the second translating signal (s2) are, respectively, a first squarewave clock signal (s1') and a second square-wave clock signal (s2') with a 1:1 mark/space ratio;
- the first multiplier (m1) and the second multiplier (m2) are replaced by a first ring modulator (r1) and a second ring modulator (r2), respectively, whose signal inputs are fed with the intermediate-frequency signal (zs) and whose switch inputs are fed with the first clock signal (s1') and the second clock signal (s2'), respectively;
- the intermediate-frequency signal (zs) is a signal filtered by means of a band-pass filter (bp) contained in the tuner (t), and
- the phase-correcting stage (pc) and the amplitude-correcting stage (ac) are designed as a single, all-digital phase- and amplitude-correcting stage (ap) which is inserted in the two signal paths between the outputs of the first and second analog-to-digital converters (w1, w2) and the taps for the digital quadrature-phase and inphase signals (Q', l').

8. A circuit arrangement as claimed in claim 7, characterized by the following features:

— A clock generator (tg) provides at its inverting output (xi) and noninverting output (xn) an inverted clock signal (ti) and an uninverted clock signal (tn), respectively, whose frequencies are equal to twice the frequency of the first or second clock signal (s1', s2'), and which have a 1:1 mark/space ratio, and

— a first single-stage binary frequency divider (b1) derives the first clock signal (s1') from the inverted clock signal (ti), and a second single-stage binary frequency divider (b2) derives the second clock signal (s1') from the uninverted clock signal (tn).

## Revendications

1. Montage pour convertir la fréquence d'un signal de télévision (hs) transmis en haute fréquence, en l'amenant dans la bande video, et comportant

— des première et seconde voies de transmission de signaux, qui sont reliées entre elles côté entrée et contiennent respectivement, dans la direction du flux de transmission de signaux, et ce dans cette succession, la première entrée d'un premier ou d'un second multiplicateur (m1, m2), un premier ou un second filtre passe-bas (t1, t2) et la première entrée d'un troisième ou d'un quatrième multiplicateur (m3, m4),

— un étage additionneur (ad), dont une entrée est reliée à la sortie du troisième multiplicateur (m3) et dont l'autre entrée est reliée à la sortie du quatrième multiplicateur (m4),

— un étage (pc) de correction de la phase et un étage (ac) de correction de l'amplitude, qui servent à régler la position de phase du signal à 90. entre les voies de transmission des signaux et l'égalité des amplitudes dans ces voies,

— et dans lequel

-- à la seconde entrée du premier ou du second multiplicateur (m1, m2) est envoyé un premier signal de mélange (s1) ou un second signal de mélange (s2) déphasé de 90. par rapport au premier, le premier ou le second signal convertissant le signal envoyé respectivement à la première entrée pour l'amener dans la position de basse fréquence intermédiaire,

-- un troisième signal de mélange (s3) ou un quatrième signal de mélange (s4), déphasé de 90. par rapport au précédent, est envoyé à la seconde entrée du troisième ou du quatrième multiplicateur (m3, m4),

-- la fréquence des premier et second signaux de mélange (s1, s2) est située dans la limite de bande du signal envoyé au côté entrée des deux voies de transmission de signaux, et

-- la bande passante des premier et second filtres passebas (t1, t2) est égale au moins à la moitié de la largeur de la bande du signal vidéo (v), caractérisé par les caractéristiques suivantes:

— en amont des deux voies de transmission de signaux est branché un synthoniseur (t), qui convertit le signal de télévisio (hs) transmis avec une haute fréquence en un signal à fréquence intermédiaire (zs),

— la fréquence des premier et second signaux de mélange (s1, s2) est constante et indépendante de la position de la fréquence du signal de télévision (hs) transmis en haute fréquence,

— respectivement un circuit série, dans la direction du flux de transmission du signal, formé par un premier ou un second filtre de Nyquist (n1, n2) et par un premier ou un second amplificateur réglable (v1, v2), est disposé entre le premier ou le second filtre passe-bas (t1, t2) et le troisième ou le quatrième multiplicateur (m3, m4),

— la fréquence à 6 dB des premier et second filtres de Nyquist (n1, n2) est égale à la fréquence de la porteuse image (bt') soumise à convolution, présente dans le signal de sortie des premier et second multiplicateurs (m1, m2),

— la sortie du premier ou du second amplificateur réglable (v1, v2) est reliée à l'entrée des signaux d'un premier ou d'un second comparateur (g1, g2), dont la sortie respective est raccordée à l'entrée de commande du premier amplificateur (v1) ou du second amplificateur réglable (v2) identique au premier,

— un démodulateur (d) est branché en aval de la sortie de l'étage additionneur (ad) et délivre le signal de télévision démodulé (= signal vidéo (v)), et

— pour le signal de sortie du premier filtre passe-bas (t1) (= signal de phase en quadrature (Q)) et pour le signal de sortie du second filtre passe-bas (t2) (= signal en phase (I)), il est prévu respectivement une prise pour le signal permettant le raccordement d'un circuit démodulateur de signaux son.

2. Montage suivant la revendication 1, caractérisé par les caractéristiques suivantes;

— dans l'étage de correction de phase (pc), les premier et second signaux de mélange (s1, s2) sont envoyés à des entrées respectives d'un détecteur de phase (pm),

— à la sortie du détecteur de phase (pm), est raccordé un troisième filtre passe-bas (t3), dont la sortie est reliée à l'entrée de commande d'un premier amplificateur de correction (k1) et d'un second amplificateur de correction (k2), identique au premier,

— dont l'entrée des signaux est raccordée directement par l'intermédiaire d'un circuit (pd) de rotation de la phase sur 90., à la sortie d'un oscillateur (cq) délivrant une fréquence constante,

— la sortie du circuit (pd) de rotation de la phase sur 90É est reliée à la première entrée d'un premier additionneur (a1), dont la seconde entrée est raccordée à la sortie du premier amplificateur de correction (k1),

— la sortie de l'oscillateur (cq) est reliée à la première entrée d'un second additionneur (a2), dont la seconde entrée est raccordée à la sortie du second amplificateur de correction (k2), et

— les signaux de sortie du premier ou du second additionneur (a1, a2) sont les premier et second signaux de mélange (s1, s2).

3. Montage suivant la revendication 1 ou 2, caractérisé par les caractéristiques suivantes:

— dans l'étage de correction d'amplitude (ac), le signal de sortie du premier ou du second amplificateur réglable (v1, v2) est envoyé à un premier ou un second circuit d'élévation au carré (q1, q2), dont la sortie respective est raccordée à l'entrée du diminuende ou à l'entrée du nombre à soustraire d'un premier soustracteur (d1),

– en aval de la sortie du premier soustracteur (d1) est branché un quatrième filtre passe-bas (t4), dont la sortie est reliée à l'entrée du nombre à soustraire d'un second soustracteur (d2) et à la première entrée d'un troisième additionneur (a3),

– la sortie du second soustracteur (d2), à l'entrée du diminuende duquel est envoyé un signal de référence (a), est raccordée à l'entrée de référence du premier comparateur (g1), et

– la sortie du troisième additionneur (a3), à la seconde entrée duquel est envoyée la valeur de référence (r) est raccordée à l'entrée de référence du second comparateur (g2).

4. Montage suivant l'une des revendications 1 à 3, caractérisé par le fait qu'on utilise comme troisième ou quatrième signal de mélange (s3, s4), le premier ou le second signal de mélange (sl, s2).

5. Montage suivant l'une des revendications 1 à 4, caractérisé par le fait que le signal de sortie du démodulateur (d) est numérisé au moyen d'un convertisseur analogique/numérique (aw).

6. Montage suivant l'une des revendications 1 à 3, caractérisé par les caractéristiques suivantes:

– un premier convertisseur analogique/numérique (w1) ou un second convertisseur analogique/numérique (w2), identique ou au précédent, est inséré entre la sortie du premier du second filtres passe-bas (t1, t2) et la prise pour le prélèvement du signal à phase en quadrature (Q) ou du signal en phase (I),

– les étages qui s'y raccordent dans la direction du flux de transmission des signaux sont réalisés sous la forme d'étages travaillant numériquement,

– comme troisième ou quatrième signal de mélange numérique (s3, s4), on utilise le signal respectif d'entrée du troisième ou du quatrième multiplicateur numérique (m3, m4) qui forme par conséquent un troisième ou un quatrième circuit d'élévation au carré (q3, q4),

– le signal de sortie de l'étage additionneur (ad), à savoir un étage additionneur numérique (a4), dont l'entrée respective est alimentée par le troisième ou le quatrième circuit d'élévation au carré (q3, q4), est la valeur, élevée au carré, du signal de télévision numérisé situé dans la bande du signal vidéo, qui, après formation numérique de la racine carré dans un étage (w) de calcul de la racine carrée, fournit le signal vidéo numérisé proprement dit (v') dans la position située dans la bande vidéo, et

– le démodulateur (d) est supprimé.

7. Montage suivant la revendication 6, caractérisé par les caractéristiques suivantes:

– le premier ou le second signal de mélange (s1, s2) est un premier ou second signal de cadence rectangulaire (s1', s2') possédant un rapport impulsion/pause entre impulsions égal à 1:1,

– le premier ou le second multiplicateur (ml, m2) est remplacé par un premier ou second modulateur en anneau (rl, r2), à l'entrée respective des signaux duquel est envoyé le signal à fréquence intermédiaire (zs) et à l'entrée respective de commutation duquel est envoyé le premier ou le second signal de cadence (s1', s2'),

– le signal à fréquence intermédiaire (zs) est un signal filtré au moyen d'un filtre passe-bande (bp) contenu dans le synthoniseur (t), et

– les étages de correction de phase et de correction d'amplitude (pc, ac) sont réalisés sous la forme d'un étage unique (pa) de correction de phase et d'amplitude, qui travaille de manière purement numérique et qui est inséré en tant que circuit partiel dans les deux voies de transmission de signaux en aval du premier ou du second convertisseur analogique/numérique (w1, w2) et de la prise prévue pour le prélèvement du signal numérique à phase en quadrature (Q') ou du signal numérique en phase (I').

8. Montage suivant la revendication 7, caractérisé par les caractéristiques suivantes:

– un générateur de cadence (tg) produit, sur sa sortie inverseuse ou sa sortie non inverseuse (xi, xa), un signal de cadence inversée ou non inversée (ti, tn), dont la fréquence est égale au double de la fréquence du premier signal ou du second signal de cadence (s1', s2') et dont le rapport impulsion/pause entre impulsions est égal à 1:1, et

– un premier ou un second diviseur de fréquence binaire à un étage (b1, b2) produit le premier ou le second signal de cadence (s1', s2') à partir du signal de cadence inversé ou non inversé (ti, tn).

Fig. 1

Fig. 2

Fig. 3

Fig. 4

Fig. 5